## Europäisches Patentamt
## European Patent Office
## Office européen des brevets

(11) Publication number: **0 068 897**
**B1**

# (12) EUROPEAN PATENT SPECIFICATION

(45) Date of publication of patent specification: **07.09.88**

(51) Int. Cl.⁴: **H 01 L 21/285,** H 01 L 21/60

(21) Application number: **82303427.7**

(22) Date of filing: **30.06.82**

(54) A method of forming an electrode of a semiconductor device.

(30) Priority: **01.07.81 JP 101214/81**

(43) Date of publication of application:
**05.01.83 Bulletin 83/01**

(45) Publication of the grant of the patent:
**07.09.88 Bulletin 88/36**

(84) Designated Contracting States:
**DE GB**

(56) References cited:
**EP-A-0 033 495**
**US-A-3 753 774**
**IBM TECHNICAL DISCLOSURE BULLETIN, vol. 19, no. 8, January 1977, page 3233, New York, USA; F.M. D'HEURLE et al.: "Metallization for shallow junction silicon technology"**
**IBM TECHNICAL DISCLOSURE BULLETIN, vol. 20, no. 3, August 1977, page 1009, New York, USA; J. GNIEWEK et al.: "Enhancement of Pt adhesion using a Si underlay"**
**IBM TECHNICAL DISCLOSURE BULLETIN, vol. 22, no. 9, February 1980, pages 4052-4053, New York, USA; F. BARSON: "Modified polysilicon emitter process"**

(73) Proprietor: **Hitachi, Ltd.**
**5-1, Marunouchi 1-chome**
**Chiyoda-ku Tokyo 100 (JP)**

(72) Inventor: **Sugaki, Shojiro**
**2-32-D302 Koyasu-cho**
**Hachioji-shi Tokyo (JP)**
Inventor: **Ogirima, Masahiko**
**2-1-23 Nakai Shinjuku-ku**
**Tokyo (JP)**
Inventor: **Yamamoto, Naoki**
**1-10-20 Shiba**
**Kawaguchi-shi Saitama-ken (JP)**

(74) Representative: **Paget, Hugh Charles Edward et al**
**MEWBURN ELLIS & CO. 2/3 Cursitor Street**
**London EC4A 1BQ (GB)**

(56) References cited:
**THIN SOLID FILMS, vol. 70, no. 2, August 1980, pages 241-247, Lausanne, CH; T.F. RETAJCZYK Jr. et al.: "Elastic stiffness and thermal expansion coefficients of various refractory silicides and silicon nitride films"**

**Description**

The present invention relates to a method of forming an electrode of a semiconductor device, and more particularly (but not exclusively) to the formation of an electrode on a silicon wafer.

As is well known, the electrodes of various semiconductor devices are principally formed by using an Al alloy as the electrode material or by producing metal silicide directly on a silicon substrate.

The use of Al alloy as the electrode material has the merit that the process is simple and that manufacture is easy. Since, however, the Al alloy is readily alloyed with Si at the low temperature of about 500°C, Al penetrates into the Si substrate by the solid-phase diffusion reaction between Si and Al. If there is a thin diffusion layer in the Si substrate the Al which has penetrated into it passes through the diffusion layer easily, resulting in the disadvantages that junction shorting occurs and that the heat resistance is conspicuously low.

The method of forming an electrode by forming metal silicide directly on the Si substrate, gives better heat resistance than the method using Al alloy. However, the metal silicide is formed by the solid phase reaction between a metal and the Si substrate, so that when it is intended to form a thick metal silicide layer, the lower part of the metal silicide extends into the Si substrate so that the interface between the silicide and the corresponding part of the Si substrate lies within the original Si substrate. Within the Si substrate, regions having opposite conductivity type to that of the Si substrate are usually formed. Therefore, when the Si-silicide interface is formed within the Si substratet, there is a risk that a junction is ruined by the metal silicide, so that the thickness of the metal silicide cannot be very large.

In order to solve this problem, there has been proposed a method in which a polycrystalline Si film heavily doped with an impurity is formed on the Si substrate in advance, and a metal film is deposited on the Si film to react with it, to form the metal silicide. This polycrystalline Si film can prevent spoiling of the junction within the substrate. Since, however the polycrystalline Si film needs to be formed in parts which are contact holes formed by a photoetching process, this method is unsuitable for the formation of a semiconductor device of high packaging density having a very fine structure.

US—A—3 753 774 describes a process in which (a) an insulating film is formed on a semiconductor substrate in a manner which exposes a part where the electrode is to be formed, (b) a Si layer is selectively grown on the exposed part, (c) a metal layer is deposited on the Si layer and (d) the resultant product is heated to form a metal silicide layer. The preferred metal is Pt. Others mentioned are Au, Ag, Pd and Rh.

Objects of the present invention are therefore to provide a method of forming the electrode of a semiconductor device which can ensure sufficient heat resistance of the electrode, which can avoid the risk of ruining a junction within a substrate and which can also be applied to the manufacture of an integrated circuit of high packaging density.

The present invention is set out in the claims. In the invention, a refractory metal selected from Mo, Ta, Ti and W is used, to form the layer which reacts with the silicon to produce a silicide capable of withstanding high temperature heat treatment.

An embodiment of the invention will now be described by way of example with reference to the accompanying drawing, in which

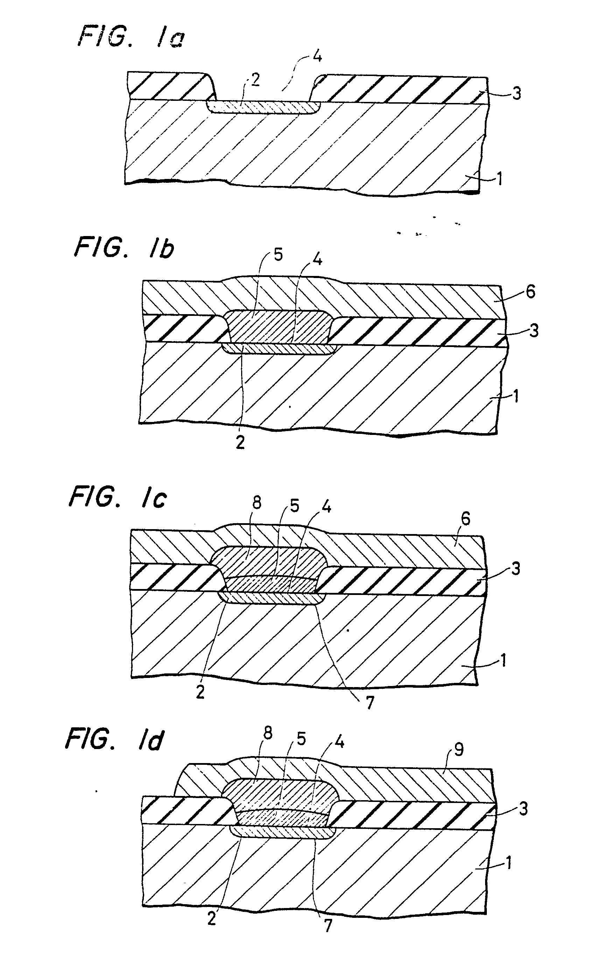

Figures 1a to 1d are processing flow diagrams illustrative of the embodiment of the invention.

As shown in Figure 1a, an impurity-doped layer 2 is formed in the surface region of a single-crystal Si substrate by a well-known method such as thermal diffusion or ion implantation.

Using a well-known process such as thermal oxidation or chemical vapor deposition (CVD), a $SiO_2$ film 3 is deposited on the whole surface of the Si substrate. Thereafter, the part of the $SiO_2$ film overlying the impurity-doped layer 2 is selectively removed by the well-known photoetching process so as to form a contact hole 4.

In this example, the deposition of the $SiO_2$ film 3 and the formation of the contact hole 4 were carried out after the impurity-doped layer 2 had been formed. The impurity-doped layer 2 however may be formed after the deposition of the $SiO_2$ film 3 and the formation of the contact hole 4.

As shown in Figure 1b, using the well-known vapor epitaxial growth technique which employs $SiCl_4$ and $H_2$, a Si epitaxial layer 5 is selectively grown on the exposed surface of the Si substrate 1. Thereafter, a refractory metal film 6 of Mo, Ta, Ti or W is deposited on the whole surface of the resultant substrate. Two or more such metals may be used jointly, or an alloy consisting of two or more such metals.

Subsequently, a heat treatment is conducted at about 500°C or above in a non-oxidizing atmosphere, so that a solid phase reaction takes place between the metal layer 6 and the Si layer 5, to form a metal silicide layer 8 as shown in Figure 1c.

The temperature of this heat treatment should preferably be in the range 500°C—1000°C. At below about 500°C, the metal silicide is difficult to form, and at above about 1000°C, the impurity-doped layer 2 spreads due to thermal diffusion and the pn-junction 7 deepens. The growth rate of the metal silicide depends greatly upon the atmosphere of the heat treatment. For example, the growth rate of the metal silicide is markedly higher in a hydrogen atmosphere than in a nitrogen atmosphere.

The thickness of the metal silicide layer 8 can be controlled to a desired value by control of the conditions of the heat treatment. In an example in which the heat treatment was conducted at 700°C in the hydrogen atmosphere for 1 hour, a tungsten silicide layer 8 about 500 nm thick was obtained.

Even if the entire Si layer 5 reacts with the metal film 6, it is only necessary that the silicide film 8 produced does not pierce the impurity-doped layer 2 to destroy the junction 7. Therefore, when the thickness of the Si epitaxial layer 5 is made sufficiently great beforehand (roughly, greater than the thickness of the metal silicide layer to be formed), the formation of the metal silicide layer 8 can be performed with a sufficient tolerance.

More specifically, when the Si epitaxial layer 5 is formed so as to be somewhat thick in advance, this layer 5 is not fully reacted in the formation of the metal silicide but is left unreacted to some degree as illustrated in Figure 1c. There is then no fear that the pn-junction 7 will be spoilt by the layer 8, and a contact having a high reliability can be formed very easily.

In the embodiment shown, the Si epitaxial layer 5 is formed on the impurity-doped layer 2. Since, however, the present invention requires only the formation of the metal silicide through the reaction with the refractory metal, it is possible to employ, instead of an Si epitaxial layer, a polycrystalline silicon layer or an amorphous silicon layer. It is difficult, however, to form an amorphous silicon layer on the selected part of the impurity-doped layer 2 without using a mask or the like. In contrast, an Si epitaxial or a polycrystalline silicon layer can be selectively grown on the impurity-doped layer 2 and these two are therefore favoured in practice.

After the metal silicide layer 8 has been formed, the refractory metal film 6 is etched and removed. The unreacted refractory metal film 6 can be selectively etched and removed by employing an etchant whose etching rate for the metal is sufficiently greater than that of the metal silicide.

For example, if Mo is the refractory metal, the Mo film only is selectively removed with the Mo silicide layer left behind if a phosphoric acid-based solution is used as the etchant. If W is the refractory metal to form W silicide, the W film only is selectively removed with the W silicide layer left behind when a hydrogen peroxide liquid is used as the etchant.

Next a wiring metal film, e.g. of Al, is deposited on the whole surface of the resultant substrate and then its unnecessary parts are removed by photoetching. A wiring layer 9 which is electrically connected with the metal silicide layer 8 is thus formed as shown in Figure 1d.

The metal silicide layer formed in the present invention can be used as the contact electrode for the impurity-doped layer within the Si substrate, for the electrode of a Schottky diode, etc. When using the metal silicide layer as the electrode of the Schottky diode, it is desirable to react the entire Si epitaxial layer with the metal silicide and to hold the metal silicide layer in direct contact with the silicon semiconductor substrate.

In the illustrated embodiment, the metal silicide layer is formed, the refractory metal layer is thereafter removed, and then the wiring layer of Al or the like is deposited so as to form the wiring. The present invention is not restricted to this order of method steps. By processing the unreacted refractory metal layer into a desired shape by photoetching, it can be used as the wiring in a variety of semiconductor devices, as the gate electrode of a MOS field effect transistor, etc. When employing the refractory metal in these ways, the metal silicide layer can be formed at the contact hole by heat treatment after the refractory metal has been processed into the desired shape by photoetching.

Since the metal silicide layer formed in the present invention can typically endure heat treatment at temperatures up to about 1,200°C, there is no risk of ruining the electrode if temperatures of various heat treatments which are conducted after the formation of the electrode are below about 1,100°C, and almost all the ordinary silicon processes can be performed without hindrance.

When wiring is formed from the unreacted part of the refractory metal used for forming the metal silicide, the heat resistance is excellent, and the specific resistance is as low as at most $2 \times 10^{-5} \, \Omega \cdot cm$. Such wiring is therefore very suitable for various semiconductor integrated circuits.

In addition, according to the present invention, Si is selectively grown on the contact hole and is reacted with the refractory metal. Therefore, the metal silicide layer is formed in a self-aligning manner, and the method can be very easily applied to the formation of a large-scale integrated circuit having a very fine structure.

**Claims**

1. A method of forming an electrode of a semiconductor device comprising the steps of:

(A) forming an insulating film (3) onto a surface of a semiconductor substrate (1) in a manner which exposed that part of the said surface on which the electrode is to be formed,

(B) selectively growing a Si layer (5) on the said exposed surface part of said semiconductor substrate (1),

(C) depositing a metal layer (6) so as to cover at least said Si layer (5), and

(D) heating the resultant substrate to react said Si layer (5) and said layer (6) to form a metal silicide layer (8),

characterised in that said metal layer (5) is a refractory metal layer formed of at least one of Mo, Ta, Ti and W.

2. A method according to claim 1 wherein after step (D) the following steps are performed:

(E) removing an unreacted part of said refractory metal layer (6) to expose a surface of said metal silicide layer (8), and

(F) forming a wiring layer (9) connected to said metal silicide layer (8).

3. A method according to claim 1 wherein after the step (D), the following step is performed:

(E') removing a predetermined part or parts of the unreacted part of said refractory metal layer (6) so as to form a wiring layer.

4. A method according to any one of claims 1 to 3, wherein said silicon layer (5) is a Si epitaxial layer, a polycrystalline Si layer or an amorphous Si layer.

## Patentansprüche

1. Verfahren zur Bildung einer Elektrode einer Halbleitervorrichtung mit folgenden Schritten:

(A) Bildung eines isolierenden Films (3) auf einer Oberfläche eines Halbleitersubstrats (1) auf eine Weise, die den Teil der Oberfläche freilegt, auf dem die Elektrode gebildet werden soll,

(B) selektives Aufwachsen einer Si-Schicht (5) auf dem freigelegten Oberflächenteil des Halbleitersubstrats (1),

(C) Abscheiden einer Metallschicht (6) so, daß zumindest die Si-Schicht (5) bedeckt wird, und

(D) Erhitzen des sich ergebenden Substrats, um die Si-Schicht (5) und die genannte Schicht (6) zur Reaktion zu bringen, um eine Metallsilizidschicht (8) zu bilden,

dadurch gekennzeichnet, daß die Metallschicht (5) eine zumindest aus einem der Elemente Mo, Ta, Ti und W gebildete hochschmelzende Metallschicht ist.

2. Verfahren nach Anspruch 1, wobei nach Schritt (D) die folgenden Schritte durchgeführt werden:

(E) Entfernen eines nicht-reagierten Teils der hochschmelzenden Metallschicht (6), um eine Oberfläche der Metallsilizidschicht (8) freizulegen, und

(F) Bilden einer Verdrahtungsschicht (9), die mit der Metallsilizidschicht (8) verbunden ist.

3. Verfahren nach Anspruch 1, wobei nach dem Schritt (D) der folgende Schritt durchgeführt wird:

(E') Entfernen eines bestimmten Teils oder bestimmter Teile des nicht-reagierten Teils der hochschmelzenden Metallschicht (6), um eine Verdrahtungsschicht zu bilden.

4. Verfahren nach einem der Ansprüche 1 bis 3, wobei die Siliziumschicht (5) eine Si-Epitaxial-

schicht, eine polykristalline Si-Schicht oder eine amorphe Si-Schicht ist.

## Revendications

1. Procédé pour fabriquer une électrode d'un dispositif semiconducteur comprenant les étapes de:

(A) former un film isolant (3) sur une surface d'un substrat semiconducteur (1) d'une manière qui expose la partie de ladite surface sur laquelle l'électrode doit être formée,

(B) faire sélectivement croître une couche (5) de Si sur ladite partie de surface exposée dudit substrat semiconducteur (1),

(C) déposer une couche de métal (6) afin de couvrir au moins ladite couche (5) de Si,

(D) chauffer le substrat résultant pour faire réagir ladite couche (5) de Si et ladite couche (6) pour former une couche (8) de siliciure de métal, caractérisé en ce que ladite couche (5) de métal est une couche d'un métal réfractaire formée d'au moins l'un de Mo, Ta, Ti et W.

2. Procédé selon la revendication 1, où, après l'étape (D), les étapes suivantes sont accomplies:

(E) enlever une partie de ladite couche (6) de métal réfractaire n'ayant pas réagi pour exposer une surface de ladite couche (8) de siliciure de métal, et

(F) former une couche de câblage (9) connectée à ladite couche (8) de siliciure de métal.

3. Procédé selon la revendication 1, où après l'étape (D), l'étape suivante est accomplie:

(E') enlever une partie prédéterminée ou des parties de la partie n'ayant pas réagi de ladite couche de métal réfractaire (6) afin de former une couche de câblage.

4. Procédé selon l'une quelconque des revendications 1 à 3, où ladite couche de silicium (5) est une couche épitaxiée de Si, une couche de Si polycristallin ou une couche de Si amorphe.

FIG. Ia

FIG. Ib

FIG. Ic

FIG. Id